(19)

Europäisches
Patentamt
European
Patent Office
Office européen
des brevets

(11) EP 2 887 400 A1

(12) EUROPEAN PATENT APPLICATION

(43) Date of publication:
24.06.2015 Bulletin 2015/26

(51) Int Cl.:
H01L 29/778 (2006.01)     H01L 29/40 (2006.01)
H01L 29/417 (2006.01)     H01L 29/423 (2006.01)
H01L 29/20 (2006.01)

(21) Application number: 14180851.9

(22) Date of filing: 13.08.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 20.12.2013 JP 2013264257

(71) Applicant: Kabushiki Kaisha Toshiba
Tokyo 105-8001 (JP)

(72) Inventor: Yamamura, Takuji
Minato-ku Tokyo (JP)

(74) Representative: Granleese, Rhian Jane
Marks & Clerk LLP
90 Long Acre
London WC2E 9RA (GB)

(54) **Field effect transistor**

(57)     A field effect transistor includes: a stacked body (11); a finger source electrode (18); a finger drain electrode (20); a finger gate electrode (22); an insulating layer (24); and a source field plate (28). The finger drain electrode (20) is provided on parallel to the finger source electrode (18). The finger gate electrode (22) has a first side surface (22a) on the finger source electrode side, a second side surface (22b) on the finger drain electrode side, and an upper surface (22c), and is provided in parallel to the finger source electrode (18). The insulating layer (24) covers the surface (11a) of the stacked body (11) and the finger gate electrode (22). The source field plate (28) includes a bottom part (28a), an upper part (28b) and a connection part (28c). Length of the upper part (28b) is larger than length of the bottom part (28a) in a cross section perpendicular to the finger gate electrode (22).

FIG. 1B

Printed by Jouve, 75001 PARIS (FR)

**Description**

<u>FIELD</u>

Embodiments described herein relate generally to a field effect transistor.

<u>BACKGROUND</u>

A field effect transistor including a heterojunction is easily operated at high voltage and high temperature above the microwave band, and is applicable to mobile radio base stations and radar devices.

In the field effect transistor, a source field plate can be provided between the finger gate electrode and the finger drain electrode. Then, the gate-drain capacitance is reduced by the electromagnetic shield effect. This can enhance the maximum stable gain.

However, the drain-source capacitance is increased. Thus, the radio frequency current flowing into the drain-source capacitance is increased with the increase of operating frequency. This decreases the power added efficiency.

<u>BRIEF DESCRIPTION OF THE DRAWINGS</u>

FIG. 1A is a schematic plan view of a field effect transistor according to a first embodiment, and FIG. 1B is a schematic sectional view thereof;

FIGS. 2A to 2E are schematic sectional views describing a method for manufacturing a HEMT according to the first embodiment;

FIG. 3A is a partial schematic sectional view of a HEMT according to a comparative example, and FIG. 3B is a schematic plan view thereof;

FIG. 4A is a graph showing the dependence of gate-source capacitance on the source field plate length, FIG. 4B is a graph showing the dependence of gate-drain capacitance on the source field plate length, and FIG. 4C is a graph showing the dependence of drain-source capacitance on the source field plate length;

FIG. 5 is a graph showing the dependence of power added efficiency on output power; and

FIGS. 6A to 6D are schematic sectional views showing variations of the source field plate, and FIG. 6E is a schematic sectional view showing a variation of the finger gate electrode;

<u>DETAILED DESCRIPTION</u>

In general, according to one embodiment, a field effect transistor includes: a stacked body; a finger source electrode; a finger drain electrode; a finger gate electrode; an insulating layer; and a source field plate. The stacked body is made of a semiconductor and includes a hetero junction generating a two-dimensional electron gas layer. The finger source electrode is provided on a surface of the stacked body. The finger drain electrode is provided on parallel to the finger source electrode on the surface of the stacked body. The finger gate electrode has a first side surface on the finger source electrode side, a second side surface on the finger drain electrode side, and an upper surface, and is provided in parallel to the finger source electrode on the surface of the stacked body. The insulating layer covers the surface of the stacked body between the first side surface of the finger gate electrode and the finger source electrode, the surface of the stacked body between the second side surface of the finger gate electrode and the finger drain electrode, and the finger gate electrode. The source field plate includes a bottom part provided on the insulating layer in parallel to the finger gate electrode and having a first side surface opposed to the finger drain electrode and a second side surface on an opposite side of the first side surface, an upper part provided on the bottom part, and a connection part connected to part of the finger source electrode. The second side surface of the bottom part is opposed to the second side surface of the finger gate electrode. Length of the upper part is larger than length of the bottom part in a cross section perpendicular to the finger gate electrode.

Various embodiments will be described hereinafter with reference to the accompanying drawings.

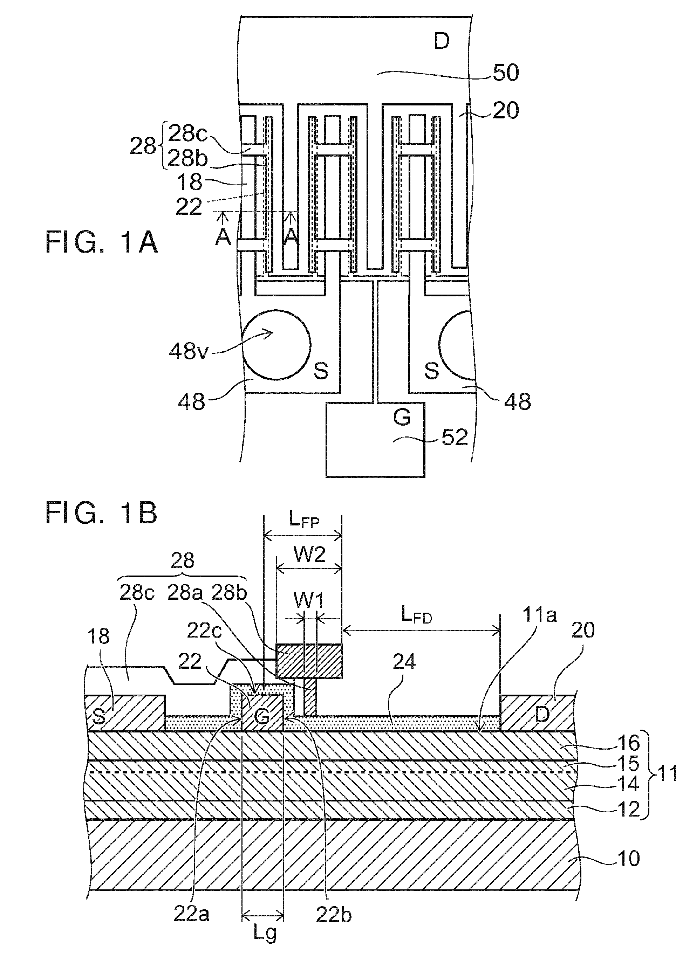

FIG. 1A is a schematic plan view of a field effect transistor according to a first embodiment. FIG. 1B is a schematic sectional view thereof.

In the first embodiment, the field effect transistor is a HEMT (high electron mobility transistor). However, the invention is not limited thereto. The field effect transistor may be a MESFET (metal semiconductor field effect transistor) or the like.

The HEMT includes a substrate 10, a stacked body 11 provided on the substrate 10 and made of semiconductor, a finger source electrode 18, a finger gate electrode 22, a finger drain electrode 20, a source field plate 28, and an insulating layer 24.

In the first embodiment, the stacked body 11 is represented by e.g. the composition formula $In_xGa_yAl_{1-x-y}N$ ($0 \leq x \leq 1$, $0 \leq y \leq 1$, $x+y \leq 1$) and may contain an element serving as a donor or acceptor. Alternatively, the stacked body 11 may be AlGaAs or the like.

The stacked body 11 includes a buffer layer 12 made of GaN or the like, a channel layer 14 provided on the buffer layer 12 and made of GaN or the like, and an electron supply layer 16 constituting a heterojunction with the channel layer 14 and made of $Al_{0.2}Ga_{0.8}N$ or the like. The thickness of the buffer layer 12 can be set in the range of e.g. 0.1-1 $\mu$m or the like. The thickness of the channel layer 14 can be set in the range of e.g. 3-20 nm or the like. The thickness of the electron supply layer 16 can be set in the range of e.g. 5-100 nm or the like. The channel layer 14 and the electron supply layer 16 can be left undoped.

Electrons moved from the electron supply layer 16 to the channel layer 14 form a two-dimensional electron gas (2DEG) layer 15. Thus, an electron gas with high mobility and high density can be formed.

The finger source electrode 18 and the finger drain electrode 20 can be provided on the surface of the electron supply layer 16 constituting the surface 11a of the stacked body 11. The finger gate electrode 22 can be provided on the surface of the electron supply layer 16 between the finger source electrode 18 and the finger drain electrode 20. The finger gate electrode 22 may be made of Ni/Au. Then, Ni and the electron supply layer 16 constitute a Schottky barrier. The drain current can be controlled by applying a control voltage to the finger gate electrode 22.

For instance, the gate length Lg can be set to 0.2-1 $\mu$m, and the spacing $L_{FPD}$ between the source field plate 28 and the finger drain electrode 20 can be set to 1-5 $\mu$m or the like.

The insulating layer 24 is provided on the surface 11a of the stacked body 11 between the finger gate electrode 22 and the finger source electrode 18 and between the finger gate electrode 22 and the finger drain electrode 20.

The insulating layer 24 may be made of SiN or $SiO_2$. This can protect the surface 11a of the stacked body 11.

The source field plate 28 includes a bottom part 28a, an upper part 28b, and a connection part 28c. The bottom part 28a is provided on the surface of the insulating layer 24 and extends along the finger gate electrode 22. The bottom part 28a is provided between the finger gate electrode 22 and the finger drain electrode 20 and near the finger gate electrode 22. The connection part 28c connects the finger part composed of the bottom part 28a and the upper part 28b to part of the finger source electrode 18. Alternatively, the connection part 28c may be an air bridge or the like.

The upper part 28b is spaced from the 2DEG layer 15 and located above the finger gate electrode 22. Thus, increasing the length W2 does not significantly affect the shield effect.

In the first embodiment, the length W2 of the upper part 28b of the source field plate 28 is larger than the length W1 of the bottom part 28a. Thus, the cross-sectional area of the finger part composed of the bottom part 28a and the upper part 28b is enlarged, and the inductance is reduced. The finger part with reduced inductance is connected to part of the finger source electrode 18 through the connection part 28c. Thus, even at high frequency, the potential of the source field plate 28 can be made close to that of the finger source electrode 18 placed at the ground potential. Here, the source field plate 28 can be made of a metal including Au.

The second side surface 22b is covered from above with the source field plate 28. This can reduce the electric field occurring in the neighborhood region of the second side surface 22b on the finger drain electrode 20 side. Thus, the breakdown voltage can be increased. This facilitates reducing the leakage current and improving the reliability. Furthermore, a radio frequency voltage with large signal can be applied. This facilitates increasing the output power.

The schematic plan view shown in FIG. 1A shows part of the HEMT chip. The cell constituting the HEMT includes a region of the stacked body 11, a finger gate electrode 22 provided on the surface thereof, a finger source electrode 18, and a finger drain electrode 20. The cell is operated as a unit transistor. As shown in FIG. 1B, high output power can be obtained by arranging many cells in parallel. Here, FIG. 1B shows a cross section taken along line A-A of FIG. 1A.

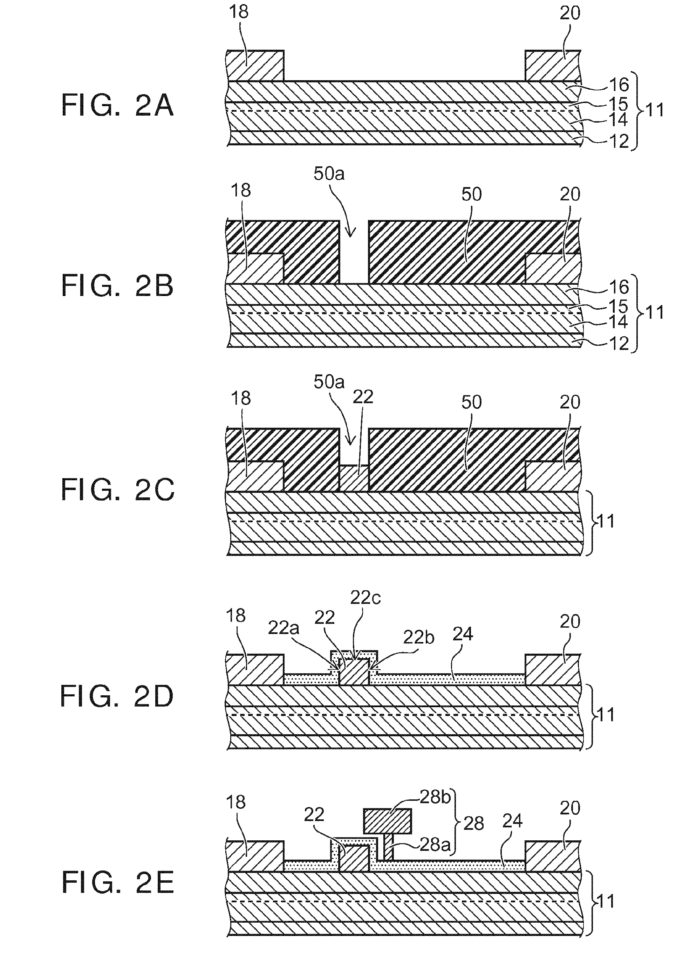

FIGS. 2A to 2E are schematic sectional views describing a method for manufacturing a HEMT according to the first embodiment.

First, a stacked body 11 including a buffer layer (not shown), a channel layer 14, and an electron supply layer 16 is formed on a substrate (not shown) by MOCVD (metal organic chemical vapor deposition) technique or the like. Next, a finger source electrode 18 and a finger drain electrode 20 are formed.

Next, as shown in FIG. 2B, a photoresist 50 is patterned. In this case, a steep side surface is easily formed by using a dry etching technique such as RIE (reactive ion etching).

Next, as shown in FIG. 2C, a finger gate electrode 22 is formed on the surface 11a of the stacked body 11 exposed in the opening 50a of the photoresist 50.

Next, as shown in FIG. 2D, an insulating layer 24 made of SiN or the like covers the surface of the stacked body 11 between the first side surface 22a of the finger gate electrode 22 and the finger source electrode 18, the surface of the stacked body 11 between the second side surface 22b of the finger gate electrode 22 and the finger drain electrode 20, and the finger gate electrode 22.

Next, as shown in FIG. 2E, the bottom part 28a of the source field plate 28 is selectively formed on the upper surface of the insulating layer 24. Furthermore, an upper part 28b is formed on the bottom part 28a. The shape of the upper part 28b of the source field plate 28 may be asymmetric. The gate-source capacitance Cgs can be reduced by forming an air gap between the upper surface of the insulating layer 24 covering the upper surface 22c of the finger gate electrode 22 and the lower surface of the upper part 28b of the source field plate 28. Furthermore, the gate-source capacitance Cgs can be reduced by forming an air gap between the insulating layer 24 covering the side surface 22b of the finger gate electrode 22 and the bottom part 28a of the source field plate 28.

Subsequently, for instance, a drain terminal electrode 50 connected to the finger drain electrode 20, a gate terminal electrode 52 connected to the finger gate electrode 22, a source terminal electrode 48 including a via hole 48v for connecting the finger source electrode 18 to the back side electrode of the chip can be provided. Thus, the HEMT shown in FIGS. 1A and 1B is completed.

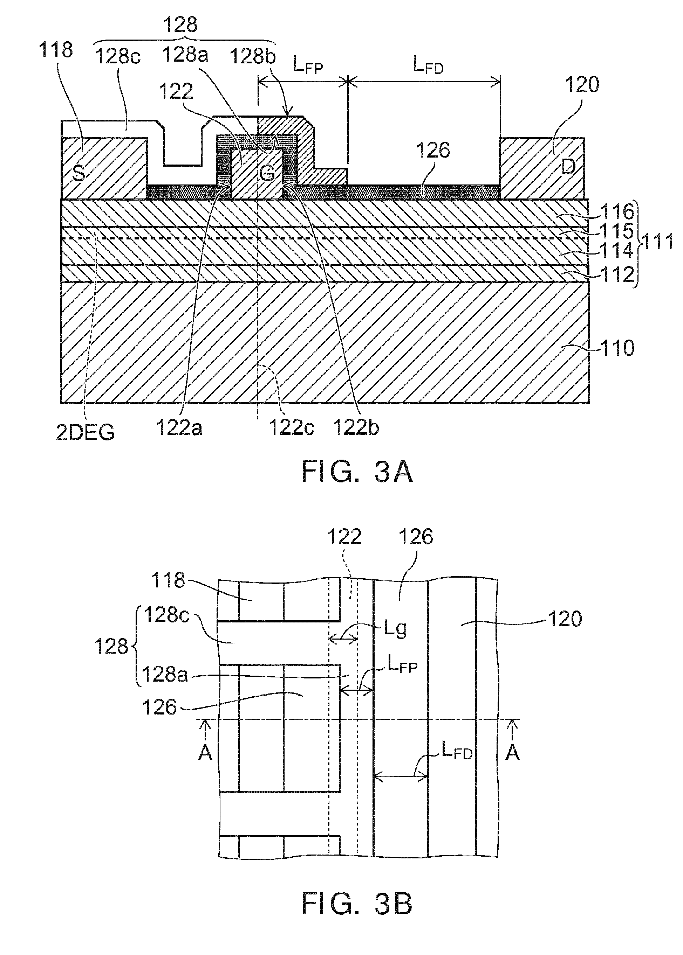

FIG. 3A is a partial schematic sectional view of a HEMT according to a comparative example. FIG. 3B is a schematic plan view thereof.

In the comparative example, the insulating layer 126 made of SiN covers the region sandwiched between the finger source electrode 118 and the finger gate electrode 122, the region sandwiched between the finger drain electrode 120 and the finger gate electrode 122, and the upper surface and two side surfaces 122a, 122b of the finger gate electrode 122. Furthermore, the source field plate 128 extends out by length $L_{FP}$ from the center line of the upper surface of the finger gate electrode 122 toward the finger drain electrode 120. The source field plate 128 is partly connected to the finger source electrode 118. Here, FIG. 3A is a schematic sectional view taken along line A-A in FIG. 3B.

In the comparative example, in the source field plate 128, the length of the bottom part 128a is generally equal to the length of the upper part 128b. The source field plate 128 includes a finger part extending out by length $L_{FP}$ from the center line 122c of the upper surface of the finger gate electrode 122 toward the finger drain electrode 120, and a connection part 128c connected to the finger source electrode 118.

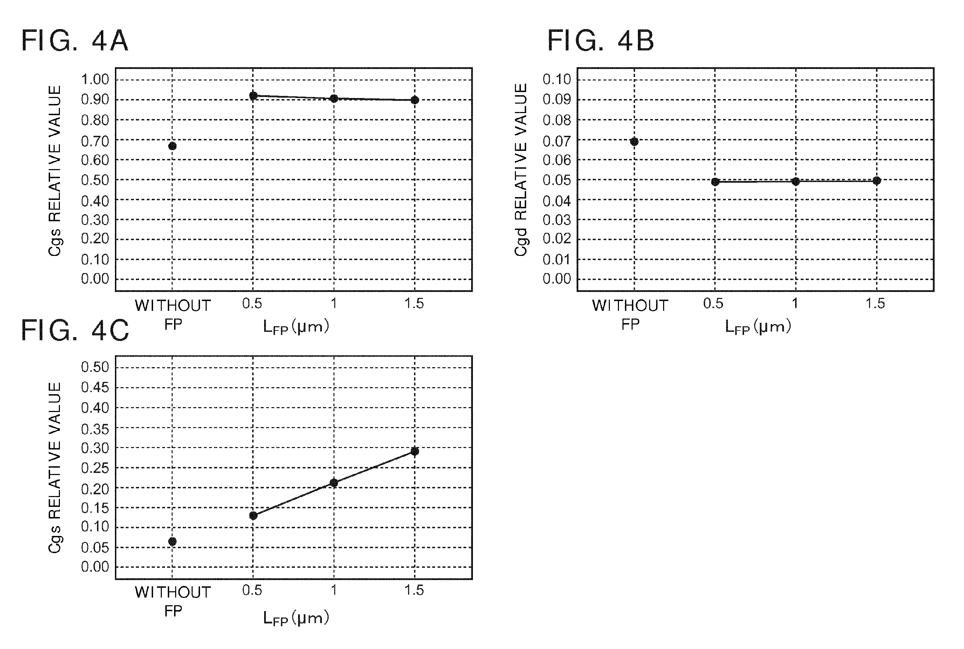

FIG. 4A is a graph showing the dependence of gate-source capacitance on the source field plate length. FIG. 4B is a graph showing the dependence of gate-drain capacitance on the source field plate length. FIG. 4C is a graph showing the dependence of drain-source capacitance on the source field plate length.

The vertical axis represents the relative value, and the horizontal axis represents the source field plate length.

As shown in FIG. 4A, by providing the source field plate, the gate-source capacitance Cgs (pF) was increased by generally 34% compared to the HEMT without the source field plate. The variation of the gate-source capacitance Cgs was as small as 2% or less for the source field plate length $L_{FP}$ in the range of 0.5-1.5 μm. A large gate-source capacitance Cgs is not preferable because of degradation in radio frequency characteristics including gain.

As shown in FIG. 4B, the gate-drain capacitance Cgd (pF) was decreased by generally 29% compared to the HEMT without the source field plate. The variation of the gate-drain capacitance was as small as 1% or less for the source field plate length $L_{FP}$ in the range of 0.5-1.5 μm. Thus, by providing the source field plate 28 connected to the finger source electrode 18, the gate-drain capacitance Cgd was reduced by generally 71% by the shield effect. Accordingly, $S_{12}$ can be reduced between the finger gate electrode 22 being an input terminal and the finger drain electrode 20 being an output terminal.

In the case where the stability factor K of the HEMT is less than 1, the maximum stable gain MSG of the HEMT is represented by equation (1) using S parameters (reverse gain: $S_{12}$, forward gain: $S_{21}$) of the four-terminal circuit.

$$MSG = \left| \frac{S_{21}}{S_{12}} \right| \qquad (1)$$

The maximum stable gain MSG can be enhanced by reducing the reverse gain $S_{12}$.

As shown in FIG. 4C, the relative value of the drain-source capacitance Cds (pF) was 0.13 when the source field plate length $L_{FP}$ was 0.5 μm. The relative value of the drain-source capacitance Cds (pF) was 0.21 when the source field plate length $L_{FP}$ was 1 μm. Furthermore, the relative value of the drain-source capacitance Cds (pF) was 0.29 when the source field plate length $L_{FP}$ was 1.5 μm. This was generally five times the relative value 0.06 in the case of providing no source field plate connected to the finger source electrode. That is, the drain-source capacitance Cds (pF) was increased generally in proportion to the source field plate length $L_{FP}$.

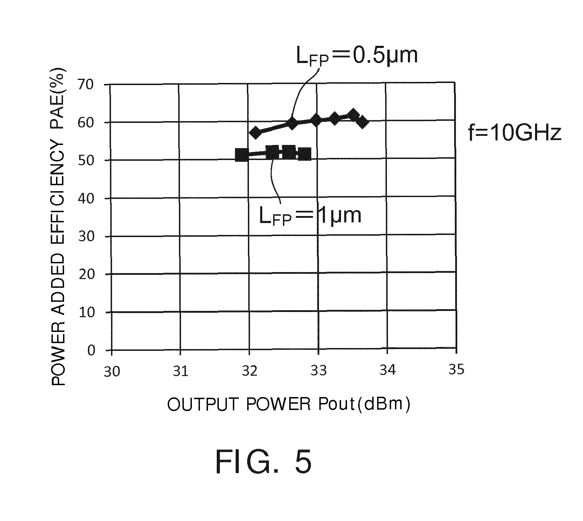

FIG. 5 is a graph showing the dependence of power added efficiency on output power.

The measurement frequency was 10 GHz, and the drain-source voltage Vds was 24 V. The vertical axis represents power added efficiency (%), and the horizontal axis represents output power (dBm). At an output power of 32.5 dBm, the power added efficiency was 60% when the source field plate length $L_{FP}$ was 0.5 μm. On the other hand, the power added efficiency was 51% when the source field plate length $L_{FP}$ was 1 μm. This was lower by 9% than that in the case where the source field plate length $L_{FP}$ was 0.5 μm.

That is, it has turned out that if the source field plate length $L_{FP}$ is decreased, the drain-source capacitance Cds can be reduced while the gate-drain capacitance Cgd is kept low, and the radio frequency current flowing into the drain-source capacitance Cds can be reduced. As a result, the power wastefully consumed in the drain resistance is reduced, and the power added efficiency can be enhanced.

On the other hand, in order to keep good radio frequency characteristics, the area of the connection part 28c partly connecting the finger part of the source field plate 28 with the finger source electrode 18 needs to be small so that the gate-source capacitance Cgs is also kept low. In the comparative example, the inductance L of the finger part of the source field plate 128 is increased. Thus, at a high frequency f, the potential of the tip part of the source field plate 128 is increased from that of the finger source electrode 118 (ground potential) by the amount corresponding to an impedance of 2πfL. This decreases the shield effect and makes it difficult to obtain a low drain-source capacitance Cds.

In the first embodiment, an upper part 28b having a large length W2 is provided on the bottom part 28a of the source field plate 28. This decreases the inductance L from the tip part of the finger part of the source field plate 28 to the finger source electrode 18. Thus, the shield effect is kept even at high frequency, and the drain-source capacitance Cds is maintained at low level. This suppresses the decrease of power added efficiency.

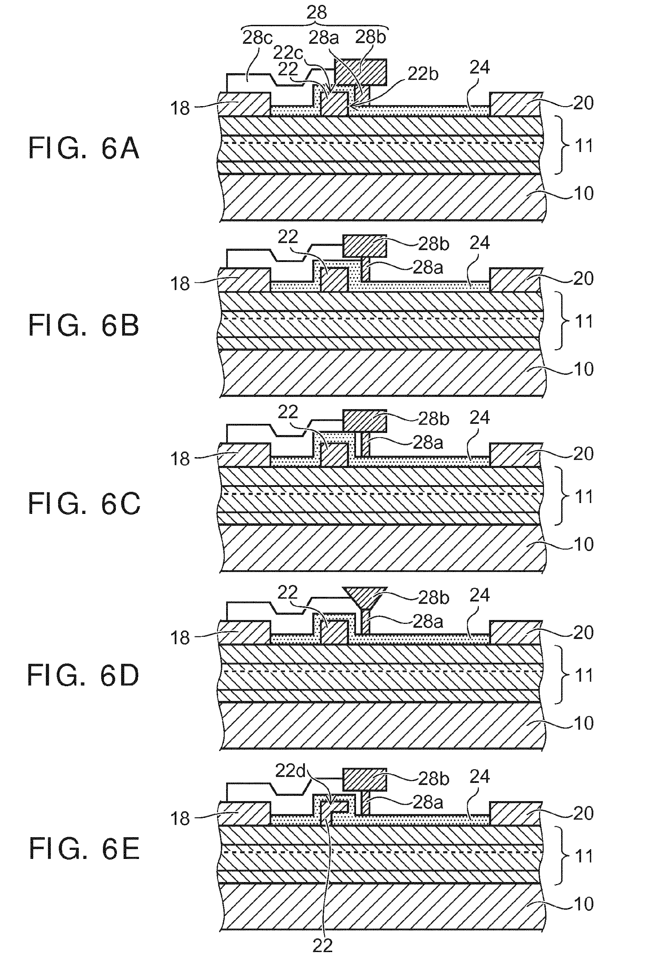

FIGS. 6A to 6D are schematic sectional views showing variations of the source field plate. FIG. 6E is a schematic sectional view showing a variation of the finger gate electrode.

FIG. 6A is a schematic sectional view showing a first variation of the source field plate 28. The second side surface of the bottom part 28a is in contact with the insulating layer 24 provided on the second side surface 22b of the finger gate electrode 22. The lower surface of the upper part 28b is in contact with the insulating layer 24 provided on the upper surface 22c of the finger gate electrode 22.

FIG. 6B is a schematic sectional view of a second variation of the source field plate 28. One side surface of the bottom part 28a is in contact with the insulating layer 24 on the second side surface 22b of the finger gate electrode 22. The lower surface of the upper part 28b is spaced by an air gap from the insulating layer 24 provided on the upper surface 22c of the finger gate electrode 22. This can make the gate-source capacitance lower than the gate-source capacitance Cgs of the first variation.

One side surface of the bottom part 28a is spaced by an air gap from the insulating layer 24 on the second side surface 22b of the finger gate electrode 22. This can make the gate-source capacitance Cgs lower than the gate-source capacitance Cgs of the first variation. The lower surface of the upper part 28b is in contact with the insulating layer 24 provided on the upper surface 22c of the finger gate electrode 22.

FIG. 6C shows a third variation of the source field plate 28. The side surface of the bottom part 28a is spaced by an air gap from the insulating layer 24 provided on the second side surface 22b of the finger gate electrode 22. The lower surface of the upper part 28b is in contact with the upper surface of the insulating layer 24 provided on the upper surface 22c of the finger gate electrode 22. The gate-source capacitance Cgs of the third variation can be made lower than the gate-source capacitance Cgs of the first variation. However, the effect of reducing the gate-drain capacitance Cgd becomes lower as the bottom part 28a is spaced farther from the second side surface 22b of the finger gate electrode 22.

FIG. 6D shows a fourth variation of the source field plate 28. The source field plate 28 is Y-shaped. Alternatively, the source field plate 28 may be V-shaped.

FIG. 6E is a schematic sectional view of a variation of the finger gate electrode 22. The finger gate electrode 22 may include a gate field plate part 22d extending out toward the finger drain electrode 20. The gate field plate 22d can reduce the electric field intensity and further increase the breakdown voltage.

The embodiments provide a field effect transistor capable of improving the power added efficiency while keeping the maximum stable gain. This field effect transistor can be widely used in radar devices, mobile radio base stations and the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

**Claims**

**1.** A field effect transistor comprising:

a stacked body (11) made of a semiconductor and including a heterojunction generating a two-dimensional electron gas layer (15);

a finger source electrode (18) provided on a surface (11a) of the stacked body (11);

a finger drain electrode (20) provided in parallel to the finger source electrode (18) on the surface of the stacked body (11);

a finger gate electrode (22) having a first side surface (22a) on the finger source electrode side, a second side surface (22b) on the finger drain electrode side, and an upper surface (22c), and provided in parallel to the finger source electrode (18) on the surface of the stacked body (11);

an insulating layer (24) covering the surface (11a) of the stacked body (11) between the first side surface (22a) of the finger gate electrode (22) and the finger source electrode (18), the surface (11a) of the stacked body (11) between the second side surface (22b) of the finger gate electrode (22) and the finger drain electrode (20), and the finger gate electrode (22); and

a source field plate (28) including a bottom part (28a) provided on the insulating layer (24) in parallel to the finger gate electrode (22) and having a first side surface opposed to the finger drain electrode (20) and a second side surface on an opposite side of the first side surface, an upper part (28b) provided on the bottom part (28a), and a connection part (28c) connected to part of the finger source electrode (18), the second side surface of the bottom part (28a) being opposed to the second side surface (22b) of the finger gate electrode (22), and length of the upper part (28b) being larger than length of the bottom part (28a) in a cross section perpendicular to the finger gate electrode (22).

2. The transistor according to claim 1, wherein
the second side surface of the bottom part (28a) and the insulating layer (24) provided on the second side surface (22b) of the finger gate electrode (22) are spaced by an air gap from each other, and
an upper surface of the insulating layer (24) and a lower surface of the upper part (28b) are in contact with each other.

3. The transistor according to claim 1 or 2, wherein
an upper surface of the insulating layer (24) and a lower surface of the upper part (28b) are spaced by an air gap from each other, and
the second side surface of the bottom part (28a) and the insulating layer (24) are in contact with each other.

4. The transistor according to one of claims 1-3, wherein the perpendicular cross section of a stacked structure of the bottom part (28a) and the upper part (28b) is Y-shaped or V-shaped.

5. The transistor according to one of claims 1-4, wherein the finger gate electrode (22) includes a gate field plate (22d) extending out toward the finger drain electrode (20).

FIG. 1A

FIG. 1B

**FIG. 2A**

**FIG. 2B**

**FIG. 2C**

**FIG. 2D**

**FIG. 2E**

FIG. 3A

FIG. 3B

FIG. 4A

FIG. 4B

FIG. 4C

FIG. 5

FIG. 6A

FIG. 6B

FIG. 6C

FIG. 6D

FIG. 6E

Europäisches
Patentamt

European
Patent Office

Office européen
des brevets

# EUROPEAN SEARCH REPORT

Application Number

EP 14 18 0851

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/069115 A1 (NAKAZAWA SATOSHI [JP] ET AL) 21 March 2013 (2013-03-21) * figures 1, 13, 14 and associated text * ----- | 1-5 | INV. H01L29/778 H01L29/40 |
| X | CN 101 419 982 A (UNIV XIDIAN [CN] UNIV XIDIAN) 29 April 2009 (2009-04-29) * figure 2 * ----- | 1,4,5 | ADD. H01L29/417 H01L29/423 H01L29/20 |
| X | US 2013/193485 A1 (AKIYAMA SHINICHI [JP] ET AL) 1 August 2013 (2013-08-01) * e.g. figure 15 and associated text * ----- | 1,3-5 | |
| X | GANG XIE ET AL: "Breakdown-Voltage-Enhancement Technique for RF-Based AlGaN/GaN HEMTs With a Source-Connected Air-Bridge Field Plate", IEEE ELECTRON DEVICE LETTERS, IEEE SERVICE CENTER, NEW YORK, NY, US, vol. 33, no. 5, May 2012 (2012-05), pages 670-672, XP011441962, ISSN: 0741-3106, DOI: 10.1109/LED.2012.2188492 * abstract * * figure 1 and associated text * ----- | 1-5 | |

TECHNICAL FIELDS
SEARCHED      (IPC)

H01L

The present search report has been drawn up for all claims

| Place of search | Date of completion of the search | Examiner |
|---|---|---|
| Munich | 7 May 2015 | Moehl, Sebastian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 14 18 0851

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2015

| Patent document cited in search report | | Publication date | Patent family member(s) | | Publication date |
|---|---|---|---|---|---|
| US 2013069115 | A1 | 21-03-2013 | JP | 5688556 B2 | 25-03-2015 |
| | | | JP | 2011249439 A | 08-12-2011 |
| | | | US | 2013069115 A1 | 21-03-2013 |
| | | | WO | 2011148443 A1 | 01-12-2011 |
| CN 101419982 | A | 29-04-2009 | NONE | | |
| US 2013193485 | A1 | 01-08-2013 | CN | 103227198 A | 31-07-2013 |
| | | | JP | 2013157407 A | 15-08-2013 |
| | | | US | 2013193485 A1 | 01-08-2013 |

EPO FORM P0459

For more details about this annex : see Official Journal of the European Patent Office, No. 12/82